# EUROPEAN PATENT APPLICATION

(11) **EP 2 541 629 A1**
(43) Date of publication of application: **02.01.2013**
(21) Application number: 10846626.9
(22) Date of filing: 29.11.2010
(51) Int. Cl.: H01L 33/48

(54) **SUBSTRATE FOR MOUNTING LIGHT EMITTING ELEMENT, AND LIGHT EMITTING DEVICE**

(30) Priority: 25.02.2010 JP 2010039850
(71) Applicant: Asahi Glass Company, Limited, Tokyo 100-8405 (JP)
(72) Inventor: NAKAYAMA, Katsuyoshi, Tokyo 100-8405 (JP); SERITA, Masayuki, Tokyo 100-8405 (JP)
(74) Representative: Müller-Boré & Partner Patentanwälte
(86) International application number: PCT/JP2010/071298
(87) International publication number: WO 2011/104963

(57) **Abstract**

To provide a substrate for mounting light-emitting elements which is a LTCC substrate for mounting light-emitting elements on which a plurality of double wire type light-emitting elements are to be mounted so as to be connected in parallel, of which the constitution of the reflection film and the wiring conductors formed on the substrate makes it possible to improve the light-extraction efficiency when formed into a light-emitting device, and a light-emitting device with a good light-extraction efficiency using it.

A substrate for mounting light-emitting elements to mount a plurality of double wire type light-emitting elements so as to be connected in parallel, comprising a substrate main body made of a sintered product of an inorganic material powder and having a mounting surface for light-emitting elements; wiring conductors provided so as to be connected to electrodes of the light-emitting elements in one-to-one at a position out of a portion between the light-emitting elements, on the mounting surface; a reflection film formed on the mounting surface excluding the wiring conductors and a periphery thereof; and an overcoat glass film provided on the mounting surface so as to cover the entire reflection film including its edge and so as to exclude the wiring conductors and a periphery thereof, and a light-emitting device using it.

## Description

### TECHNICAL FIELD

The present invention relates to a substrate for mounting light-emitting elements, and a light-emitting device using it.

### BACKGROUND ART

In recent years, along with a tendency to high brightness and whitening of a light-emitting diode element (chip), a light-emitting device employing a light-emitting diode element has been used for e.g. backlights of cellular phones or large-sized liquid crystal TVs. However, as the heat value is increased along with the tendency to high brightness of a light-emitting diode element and its temperature is excessively increased, a sufficient light-emitting brightness is not necessarily obtained. Accordingly, as a substrate for a light-emitting element to mount a light-emitting element such as a light-emitting diode element, a substrate from which heat generated from the light-emitting element is quickly dissipated and with which a sufficient light-emitting brightness can be obtained, is desired.

Heretofore, as a substrate for mounting a light-emitting element, for example, an alumina substrate has been used. Further, as the thermal conductivity of an alumina substrate is at a level of from 15 to 20 W/m·K and is not necessarily high, use of an aluminum nitride substrate having a higher thermal conductivity has also been studied.

However, the material cost of the aluminum nitride substrate is high, and the process cost tends to be high as it is hardly sintered and thus high temperature firing is necessary. Further, the coefficient of thermal expansion of the aluminum nitride substrate is so low as from 4×10⁻⁶ to 5×10⁻⁶/°C, and if such an aluminum nitride substrate is mounted on a general-purpose printed board having a coefficient of thermal expansion of at least 9×10⁻⁶/°C, a sufficient connection reliability is not necessarily obtained due to the difference in the thermal expansion.

To overcome such problems, use of a low temperature co-fired ceramic substrate (hereinafter referred to as a LTCC substrate) as the substrate for mounting a light-emitting element has been studied. The LTCC substrate comprises, for example, glass and an alumina filler. As their refractive index difference is significant, their interface is large, and as the thickness of the substrate is thicker than the wavelength to be utilized, a high reflectance can be obtained, whereby light from the light-emitting element can efficiently be utilized and as a result, the heat value can be reduced. Further, as it is made of an inorganic oxide which is less likely to be deteriorated by the light source, it can maintain a stable color tone over a long period.

One of characteristics of the LTCC substrate as the substrate for mounting light-emitting elements is having a high reflectance as mentioned above, and for the purpose of reflecting light emitted from the light-emitting element forward as far as possible, an attempt to apply a silver reflection film on the surface of the LTCC substrate and to form an overcoat glass on the surface of the silver reflection film to prevent oxidation or sulfurization, has been made. Here, in a case where a silver reflection film is provided on the LTCC substrate for mounting light-emitting elements, the larger its area, the higher the light-extraction efficiency, however, a wire bonding type light-emitting element which is usually mounted on the LTCC substrate requires wiring conductors on the same plane as the substrate, and it is necessary to provide a gap to secure insulation between the silver reflection film and the wiring conductors.

However, such a problem arises that from the gap formed for insulation, light enters into the LTCC substrate and the most of the entered light is diffusely reflected in the substrate and reradiation is difficult, and accordingly the presence of the gap leads to a decrease in the reflectance of the substrate. Particularly in a substrate for mounting light-emitting elements on which a plurality of light-emitting elements are connected in parallel, since for each of the light-emitting elements in a form such that each of electrodes in a pair is connected to the substrate by wire bonding (hereinafter referred to as "double wire type" as the case requires), a pair of wiring conductors for the wire bonding is required on the mounting surface, the wiring conductors are provided at a portion between the light-emitting elements. Thus, there has been a problem such that a silver reflection film having a high reflection efficiency cannot be formed at a portion between the light-emitting elements with a relatively high light emission intensity, and further, light leaks from the gap between the silver reflection film and the wiring conductors, and no sufficient light-extraction efficiency will be obtained. Accordingly, for the LTCC substrate for mounting light-emitting elements, development of a technique to make the area of the reflection film such as the silver reflection film on the mounting surface as large as possible, and to make the area of the gap between the silver reflection film and the wiring conductors as small as possible, etc., has been desired so as to improve the light-extraction efficiency of the light-emitting element.

As a technique to overcome the decrease in the reflection efficiency by the insulation portion in the substrate for mounting light-emitting elements, for example, technique as disclosed in Patent Documents 1 and 2 has been known, although the structure is different from the above LTCC substrate. Patent Document 1 discloses an invention regarding a substrate for mounting light-emitting elements having such a constitution that a light reflection layer made of a metal and an insulating layer to cover the light reflecting layer are formed, and wiring conductors are provided on the insulating layer, so as to reduce the gap between the wiring conductors on the substrate for mounting light-emitting elements. Further, Patent Document 2 discloses an invention regarding a substrate for mounting light-emitting elements having such a constitution that on an aluminum nitride substrate, a conductor wiring pattern and an insulating layer made of an aluminum nitride paste differing in the sintering temperature from an aluminum nitride composition constituting the substrate, are provided, to prevent light from entering into the substrate through gaps in the conductor wiring pattern on the aluminum nitride substrate.

Further, among light-emitting devices on which a plurality of light-emitting elements are mounted on the same substrate, with respect to a light-emitting device in a form such that light-emitting elements are connected in series, which requires not so many wiring conductors on the substrate, a technique to increase the light-extraction efficiency by changing the shape of the light-emitting elements or their disposition on the substrate has been proposed (Patent Documents 3 and 4).

However, with respect to an LTCC substrate having a reflection film and a plurality of wiring conductors on the substrate, in a form such that a plurality of double wire type light-emitting elements are mounted to be connected in parallel as mentioned above, an attempted to increase the light-extraction efficiency when formed into a light-emitting device by efficiently using the reflection film by changing the constitution such as disposition of the reflection film and the wiring conductors, has not yet been known.

### PRIOR ART DOCUMENTS

### PATENT DOCUMENTS

Patent Document 1: JP-A-2006-100444
Patent Document 2: JP-A-2008-34513
Patent Document 3: JP-A-10-326910
Patent Document 4: JP-A-2005-109212

### DISCLOSURE OF INVENTION

### TECHNICAL PROBLEM

The present invention has been made to overcome the above problems and its object is to provide a substrate for mounting light-emitting elements on which a plurality of double wire type light-emitting elements are to be mounted so as to be electrically connected in parallel, of which the constitution of a reflection film and wiring conductors formed on the substrate makes it possible to improve the light-extraction efficiency when formed into a light-emitting device, and a light-emitting device having a good light-extraction efficiency using it. Particularly, its object is to provide a substrate for mounting light-emitting elements using a LTCC substrate, and a light-emitting device having a good light-extraction efficiency, using it.

### SOLUTION TO PROBLEM

The substrate for mounting light-emitting elements of the present invention is a substrate for mounting light-emitting elements to mount a plurality of light-emitting elements in such a form that each of electrodes in a pair is connected to the substrate by wire bonding, so as to be electrically connected in parallel, comprising:
a substrate main body made of a sintered product of an inorganic material powder and having a mounting surface to be partially mounting portions on which the light-emitting elements are to be mounted,
at least multiple times the number of the light-emitting elements of wiring conductors provided so as to be connected to the respective electrodes in a pair which the light-emitting elements have, in one-to-one by wire bonding, at a position out of a portion between the light-emitting elements, on the mounting surface of the substrate main body,
a reflection film formed on the mounting surface excluding the wiring conductors and a periphery thereof, and
an overcoat glass film provided on the mounting surface so as to cover the entire reflection film including its edge and so as to exclude the wiring conductors and a periphery thereof.

The sintered product of the inorganic material powder is a sintered product of a glass ceramic composition containing a glass powder and a ceramic filler, or a sintered product of an alumina ceramic composition containing an alumina powder and a sintering aid.

As the material constituting the reflection film in the substrate for mounting light-emitting elements of the present invention, a metal powder of e.g. silver, a mixture of silver and palladium, a silver/palladium alloy, a mixture of silver and platinum, or a silver/platinum alloy may be used. Among them, in the present invention, a reflection film substantially comprising silver having a high reflectance is preferred. Here, a reflection film substantially comprising silver means that in a case where the reflection film is formed by a silver paste, it may contain glass frit contained in the silver paste. In such a case, the glass frit may be contained up to 10%. Further, a reflection film substantially comprising silver means a reflection film containing at least 85 atomic% of silver, and a silver alloy is included. For example, palladium or platinum may be contained up to 5%.

The substrate for mounting light-emitting elements of the present invention may be applicable without any restriction to a light-emitting device having a constitution such that a plurality of double wire type light-emitting elements are mounted so as to be electrically connected in parallel, and it is preferably used for a light-emitting device having such a constitution that two double wire type light-emitting elements are mounted, each mounting surface is substantially rectangular, and mounting portions of the light-emitting elements are at the substantially center portion of the respective regions formed by equally dividing the mounting surface by a line in parallel with its short side. In such a case, the wiring conductors are arranged at four portions so that they are connected to the respective electrodes in a pair which the two light-emitting elements have, in one-to-one. They are preferably arranged at four corners on the mounting surface, so that the reflection film can be provided in a larger area on the mounting surface.

In the substrate for mounting light-emitting elements of the present invention, in order that a plurality of double wire type light-emitting elements are mounted so as to the electrically connected in parallel, and that a Zener diode can be mounted to prevent over voltage, it is preferred that any one of the wiring conductors is formed to have a larger area than the other wiring conductors for mounting a Zener diode.

Further, the present invention provides a light-emitting device comprising the substrate for mounting light-emitting elements of the present invention, and a plurality of light-emitting elements in such a form that each of electrodes in a pair is connected to the substrate by wire bonding, mounted on the mounting portions of the substrate for mounting light-emitting elements so as to be electrically connected in parallel, wherein the respective electrodes in a pair which the light-emitting elements have, are connected to the wiring conductors in one-to-one by wire bonding.

In the light-emitting device of the present invention, it is preferred with a view to improving the light-extraction efficiency that the plurality of light-emitting elements are two substantially cuboidal light-emitting elements of which the surface to be mounted on the substrate is substantially rectangular, the mounting surface of the substrate is substantially rectangular, and the light-emitting elements are mounted on substantially center portions of regions formed by equally dividing the mounting surface of the substrate by a line in parallel with its short side, so that the long side of the surface on which the light-emitting elements are to be mounted is in parallel with the short side of the mounting surface of the substrate.

### ADVANTAGEOUS EFFECTS OF INVENTION

According to the present invention, it is possible to provide a substrate for mounting light-emitting elements to mount a plurality of double wire type light-emitting elements to be electrically connected in parallel, in which a reflection film formed together with wiring conductors is disposed in a large area effectively on the substrate, and which is excellent in the light-extraction efficiency when formed into a light-emitting device. Further, it is possible to provide a light-emitting device having a good light-extraction efficiency by using the substrate for mounting light-emitting elements.

### BRIEF DESCRIPTION OF DRAWINGS

Fig. 1 is a plan view illustrating one embodiment of a substrate for mounting light-emitting elements of the present invention, as observed from above.
Fig. 2 is a cross sectional view illustrating a part corresponding to the line X-X' in Fig. 1 of the embodiment of a substrate for mounting light-emitting elements as shown in Fig. 1.
Fig. 3 is a plan view illustrating one embodiment of a light-emitting device of the present invention, as observed from above.
Fig. 4 is a cross sectional view illustrating a part corresponding to the line X-X' in Fig. 3 of the embodiment of a light-emitting device as shown in Fig. 3.
Fig. 5 is a plan view illustrating a conventional light-emitting device used for comparison in Examples, as observed from above.
Fig. 6 is a cross sectional view illustrating a part corresponding to the line X-X' in Fig. 5 of the conventional light-emitting device shown in Fig. 5.

### DESCRIPTION OF EMBODIMENTS

Now, the embodiment of the present invention will be described with reference to drawings.

The substrate for mounting light-emitting elements of the present invention is a substrate for mounting light-emitting elements to mount a plurality of double wire type light-emitting elements so as to be electrically connected in parallel, comprising a substrate main body made of a sintered product of an inorganic material powder and having a mounting surface to be partially mounting portions on which the light-emitting elements are to be mounted; at least multiple times the number of the light-emitting elements of wiring conductors provided so as to be connected to the respective electrodes in a pair which the light-emitting elements have, in one-to-one by wire bonding, at a position out of a portion between the light-emitting elements, on the mounting surface of the substrate main body; a reflection film formed on the mounting surface excluding the wiring conductors and a periphery thereof; and an overcoat glass film provided on the mounting surface so as to cover the entire reflection film including its edge and so as to exclude the wiring conductors and a periphery thereof. As the sintered product of the inorganic material powder, a LTCC substrate which is a sintered product of a glass ceramic composition containing a glass powder and a ceramic filler, or an alumina substrate which is a sintered product of an alumina ceramic composition containing an alumina powder and a sintering aid, can be used.

According to the present invention, in the substrate for mounting light-emitting elements on which a plurality of double wire type light-emitting elements are to be mounted so as to be electrically connected in parallel, by providing the wiring conductors to be connected to the electrodes in a pair which the light-emitting elements have, in one-to-one by wire bonding, at a position out of a portion between the light-emitting elements, a reflection film can be formed in a large area at a portion between the light-emitting elements with a relatively high light emission intensity, and a gap between the wiring conductor and the reflection film can be disposed at a position with a relatively small light emission intensity. Accordingly, when the substrate for mounting light-emitting elements is used as a light-emitting device on which light-emitting elements are mounted, light emitted from the light-emitting elements is reflected with good efficiency, and light which enters into the substrate from the gap between the wiring conductor and the reflection film can be reduced, whereby a light-emitting device having a high light-extraction efficiency can be achieved.

Here, "a portion between the light-emitting elements on the mounting surface of the above substrate for mounting light-emitting elements" means a range on the mounting surface surrounded by lines which are extensions of sides of the respective light-emitting elements to be mounted, facing the other.

Now, the substrate for mounting light-emitting elements of the present invention will be described with reference to one embodiment of the substrate for mounting light-emitting elements having such a constitution that the mounting surface on which two double wire type light-emitting elements are to be mounted so as to be electrically connected in parallel, is substantially rectangular, to which the substrate for mounting light-emitting elements of the present invention is preferably applied. However, the present invention is not limited thereto.

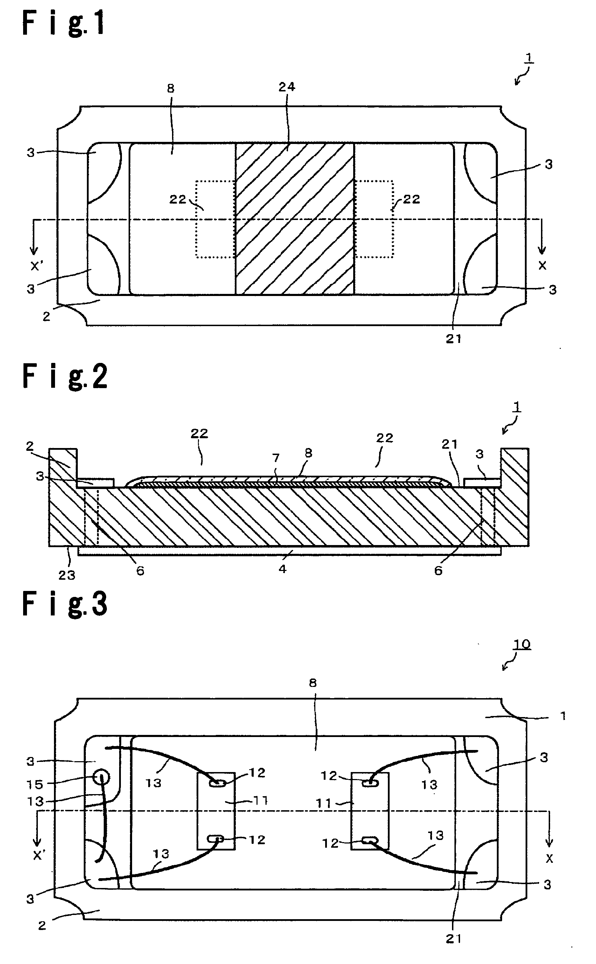

Fig. 1 is a plan view illustrating one embodiment of a substrate for mounting light-emitting elements of the present invention having a substantially rectangular mounting surface to mount two light-emitting elements, as observed from above. Fig. 2 is a cross sectional view illustrating a portion corresponding to the line X-X' in Fig. 1 of the embodiment of a substrate for mounting light-emitting elements shown in Fig. 1.

The substrate 1 for mounting light-emitting elements comprises a substrate main body 2 which has a substantially plate form and which is substantially rectangular as observed from above, mainly constituting the substrate 1 for mounting light-emitting elements. The substrate main body 2 is made of a sintered product of a glass ceramic composition containing a glass powder and a ceramic filler or a sintered product of an alumina ceramic composition containing an alumina powder and a sintering aid, and is formed in a form such that one surface (upper side in Fig. 2) has a cavity, and the bottom of the cavity forms a mounting surface 21 on which light-emitting elements are to be mounted. This mounting surface 21 is substantially rectangular, and each of substantially center portions in the respective regions formed by equally dividing the mounting surface by a line in parallel with the short side of the rectangle, forms a mounting portion 22 on which a light-emitting element is practically to be mounted. Further, the other side of the substrate main body 2 forms a non-mounting surface 23 on which no light-emitting element is to be mounted. The substrate main body 2 preferably has, for example, a flexural strength of at least 250 MPa with a view to suppressing e.g. breakage at the time of mounting light-emitting elements or at the time of use after mounting.

In the present embodiment, the shape of the substrate main body 2 is substantially plate form which is substantially rectangular as observed from above, so as to mount two double wire type light-emitting elements so as to be electrically connected in parallel, however, in the present invention, the shape, the thickness, the size etc. of the substrate main body 2 are not particularly limited, and may be the same as those of one used for a conventional substrate for mounting light-emitting elements, in accordance with the number and the disposition manner of the light-emitting elements to be mounted, and the design of the light-emitting device. Further, the material composition, the sintering conditions, etc. of the sintered product of a glass ceramic composition containing a glass powder and a ceramic filler or the sintered product of an alumina ceramic composition containing an alumina powder and a sintering aid, constituting the substrate main body 2, will be described in the after-mentioned process for producing the substrate for mounting light-emitting elements.

On the substrate main body 2, wiring conductors 3 to be electrically connected to the light-emitting elements are provided at four corners on the mounting surface 21. On the substrate 1 for mounting light-emitting elements, two light-emitting elements each having a pair of electrodes are mounted on the two mounting portions 22 respectively. On that occasion, the two light-emitting elements are disposed so that each of electrodes which the respective light-emitting elements have is connected to the closest wiring conductor 3 on the mounting surface, in one-to-one by wire bonding. On the non-mounting surface 23, an external electrode terminal 4 is provided so that the two light-emitting elements are electrically connected in parallel, and in the interior of the substrate main body 2, through hole conductors 6 to electrically connect the wiring conductors 3 and the external electrode terminal 4 are provided.

The wiring conductors 3 are provided at the predetermined positions on the mounting surface 21 in a shape and a size such that they can be connected to the electrodes of the light-emitting elements by wire bonding. In the substrate 1 for mounting light-emitting elements of the present invention, the wiring conductors 3 are arranged on the mounting surface 21 at a position out of a portion between the light-emitting elements to be mounted. As described above, a portion between the light-emitting elements on the mounting surface 21 means a range on the mounting surface surrounded by lines which are extensions of sides of the respective light-emitting elements to be mounted, facing the other light-emitting element, and in the embodiment shown in Fig. 1, the portion between the light-emitting elements is a range 24 marked with diagonal lines.

The wiring conductors 3 can be arranged at any position without any particular restriction so long as they are arranged at a position out of the portion 24 between the light-emitting elements, in accordance with the shape, the positions, etc. of the light-emitting elements to be mounted. Preferred positions of the wiring conductors 3 are positions as far as possible from the light emission center of the light-emitting elements on the mounting surface 21, and in the embodiment shown in Figs. 1 and 2, they correspond to four corners on the mounting surface.

Here, in the present embodiment, the wiring conductors 3 are formed in substantially the same shape and area at four corners on the substantially rectangular mounting surface 21. In a case where a Zener diode which is commonly used to prevent excessive voltage to the light-emitting elements is to be mounted in a light-emitting device using such a substrate 1 for mounting light-emitting elements, when any one of the wiring conductors 3 is arranged to have a larger area than the other wiring conductors 3, a Zener diode can be mounted on such a wiring conductor 3. Further, in this embodiment, the number of the wiring conductors 3 arranged on the mounting surface is twice the number of the light-emitting elements to be mounted, i.e. four which is the same as the total number of electrodes which the light-emitting elements have, and is the minimum number. However, the number may suitably be increased as the case requires, if the substrate 1 for mounting light-emitting elements requires wiring conductors in addition.

Further, to provide the wiring conductors 3, stepped portions may be provided on the mounting surface 21, and the wiring conductors 3 are formed on the stepped portions, whereby the area of the after-mentioned non-coated portion on the mounting surface formed between an overcoat glass film and the wiring conductor, arranged on the reflection film, as described hereinafter, can be made small, thus contributing to the improvement in the light-extraction efficiency when formed into a light-emitting device.

The material constituting the wiring conductor is not particularly limited so long as it is the same constituting material as for the wiring conductor to be commonly used for a substrate for mounting light-emitting elements, and specifically, it will be described in the after-mentioned production process. Further, the preferred thickness of the wiring conductor is from 5 to 15 µm.

The shapes and the constituting materials of the external electrode terminal 4 and the through hole conductors 6 are not particularly limited so long as they are the same as those of conventional ones used for a substrate for mounting light-emitting elements. Further, the positions of the external electrode terminal 4 and the through hole conductors 6 are not particularly limited so long as the two light-emitting elements to be mounted are electrically connected in parallel through the wiring conductors 3 and them.

In the substrate 1 for mounting light-emitting elements, a reflection film 7 is formed on the surface excluding the wiring conductors 3 arranged at four corners on the mounting surface 21 and a periphery thereof, and on the reflection film 7, an overcoat glass film 8 is provided so as to cover the entire reflection film 7 including its edge and so as to exclude the wiring conductors and a periphery thereof.

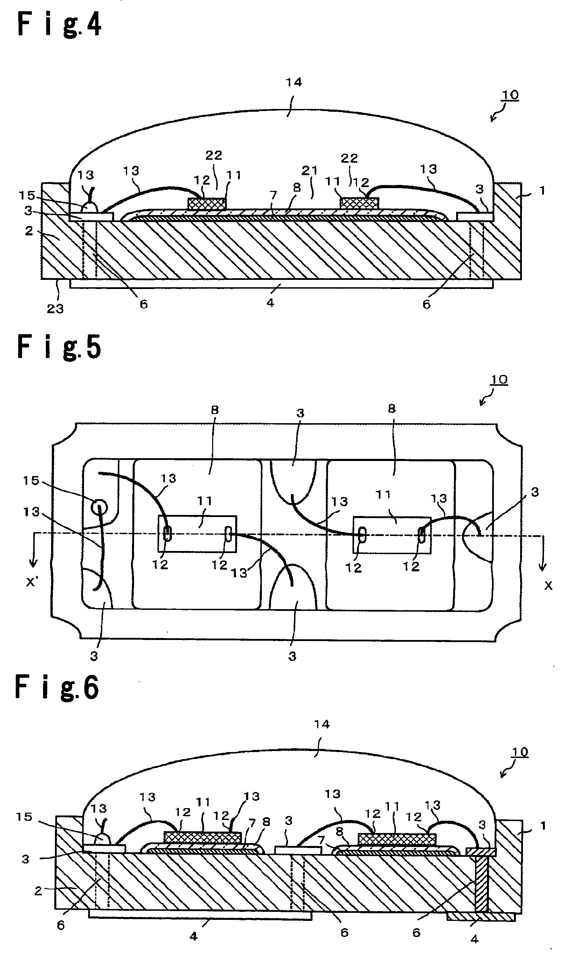

In this embodiment, by the wiring conductors 3 being arranged at four corners on the mounting surface 21, not the portion 24 between the two light-emitting elements to be mounted, it becomes possible to form the reflection film 7 on the entire portion 24 between the light-emitting elements with a relatively high light emission intensity. Further, as there are no wiring conductor 3 at the portion 24 between the light-emitting elements, the non-coated portion to be formed between the overcoat glass film 8 arranged on the reflection film 7 and the wiring conductors 3, is also not present at the portion 24 between the light-emitting elements. In a conventional substrate 1 for mounting light-emitting elements on which two double wire type light-emitting elements are to be mounted in parallel connection on a substantially rectangular mounting surface in the same manner as the present embodiment, as shown in Fig. 5, two wiring conductors are provided at the portion between the light-emitting elements, and accordingly a reflection film 7 cannot be formed in a sufficient area at the portion between the light-emitting elements. Further, since the non-coated portion to be formed between the overcoat glass film 8 arranged on the reflection film 7 and the wiring conductors 3 is present at this portion between the light-emitting elements, the light-extraction efficiency is low when formed into a light-emitting device. The substrate 1 for mounting light-emitting elements of the present invention overcomes such conventional problems by the above constitution, and the light-extraction efficiency is remarkably improved when formed into a light-emitting device.

The thickness of the reflection film 7 depends on the design of a light-emitting device for which the substrate 1 for mounting light-emitting elements is to be used, and it is preferably at least 5 µm to obtain sufficient reflection performance, and is preferably at most 50 µm considering the economical efficiency, the deformation due to the difference in the thermal expansion from the substrate, etc. Further, the thickness of the overcoat glass film 8 also depends on the design of a light-emitting device for which the substrate 1 for mounting light-emitting elements is to be used, and is preferably from 10 to 50 µm considering the thermal conductivity, the deformation due to the difference in the thermal expansion from the substrate, etc. The material composition regarding the reflection film 7 and the overcoat glass film 8 will be described in the after-mentioned production process.

In the mounting surface 21, the area of the non-coated portion on which neither wiring conductors 3 nor overcoat glass film 8 is arranged, is preferably as small as possible. However, the width of the non-coated portion is preferably at least 75 µm, more preferably at least 100 µm considering occurrence of drawbacks in production.

Further, the distance between the edge of the reflection film 7 and the edge of the overcoat glass film 8 covering the reflection film 7 is preferably as short as possible within a range where the reflection film 7 is sufficiently protected from the external deteriorating factors. Specifically, it is preferably from 10 to 50 µm, more preferably from 20 to 30 µm. If this distance is less than 10 µm, due to exposure of the reflection film 7, oxidation, sulfurization or the like of the material constituting the reflection film 7 may occur, whereby the reflectance may be decreased, and if it exceeds 50 µm, the region where the substrate main body is covered only with the overcoat glass film 8 tends to be increased, whereby the reflectance may be decreased.

Further, although not shown, thermal vias may be embedded in the interior of the substrate main body 2 to reduce the thermal resistance. A thermal via is a column smaller than the mounting portion 22 for example, and a plurality of thermal vias are provided directly below the mounting portion 22. In a case where thermal vias are provided, they are preferably provided over from the non-mounting surface 23 to the vicinity of the mounting surface 21 so that they do not reach the mounting surface 21. By such a disposition, flatness of the mounting surface 21 particularly the mounting portion 22 can be improved, the thermal resistance can be reduced, and the inclination when light-emitting elements are mounted can be suppressed.

The embodiment of the substrate 1 for mounting light-emitting elements of the present invention is described with reference to one example, however, the substrate for mounting light-emitting elements of the present invention is not limited thereto. Various changes and modifications are possible without departing from the intention and the scope of the present invention, and as the case requires.

A light-emitting device 10 of the present invention is a light-emitting device 10 comprising the above substrate 1 for mounting light-emitting elements of the present invention, and a plurality of light-emitting elements in such a form that each of electrodes in a pair is connected to the substrate by wire bonding, mounted on the mounting portions 22 of the above substrate 1 for mounting light-emitting elements, so as to be electrically connected in parallel, wherein the respective electrodes in a pair which the light-emitting elements 11 have, are connected to the wiring conductors 3 in one-to-one by wire bonding.

In the light-emitting device 10 of the present invention, it is preferred with a view to improving the light-extraction efficiency that the plurality of light-emitting elements 11 are two substantially cuboidal light-emitting elements 11 of which the surface to be mounted on the substrate is substantially rectangular, the mounting surface 21 of the substrate is substantially rectangular, and the light-emitting elements 11 are mounted on substantially center portions of regions formed by equally dividing the mounting surface 21 of the substrate by a line in parallel with its short side, so that the long side of the surface on which the light-emitting elements 11 are to be mounted is in parallel with the short side of the mounting surface 21 of the substrate. Now, the light-emitting device of the present invention will be described in detail with reference to the light-emitting device 10 having the above constitution which is a preferred embodiment of the light-emitting device 10 of the present invention. However, the light-emitting device of the present invention is not limited thereto.

Fig. 3 is a plan view illustrating one embodiment of a light-emitting device of the present invention on which two double wire type light-emitting elements 11 are mounted, as observed from above. Fig. 4 is a cross sectional view illustrating a portion corresponding to the line X-X' in Fig. 3 of the embodiment of the light-emitting device 10 shown in Fig. 3.

The light-emitting device 10 shown in Figs. 3 and 4 is a light-emitting device 10 prepared by using a substrate for mounting light-emitting elements having the same constitution as the one embodiment of the substrate 1 for mounting light-emitting elements of the present invention shown in the above Figs. 1 and 2 except that one of the wiring conductors 3 is formed to have a larger area than the other three wiring conductors 3, as the substrate 1 for mounting light-emitting elements. On the light-emitting device 10, two substantially cuboidal double wire type light-emitting elements 11 such as light-emitting diode elements of which the surface to be mounted on the substrate is substantially rectangular, are mounted on the two mounting portions 22 on the substrate 1 for mounting light-emitting elements, so that the long side of the surface of the light-emitting element 11 to be mounted is in parallel with the short side of the mounting surface 21.

In the light-emitting device 10 shown in Figs. 3 and 4, the substantially center portions of regions formed by equally dividing the mounting surface of the substrate by a line in parallel with its short side are mounting portions 22, and the positions of the mounting portions 22 are more specifically substantially center portions of regions formed by equally dividing the portion covered with the reflection film 7 and the overcoat glass film 8 on the substrate mounting surface 21, by a line in parallel with the short side of the mounting surface 21.

Two light-emitting elements 11 are fixed by an adhesive (not shown) to the mounting portions 22, and electrodes 12 in a pair which the light-emitting elements have, are electrically connected to the wiring conductors 3 located at four corners on the mounting surface, in one-to-one by bonding wires 13. In each substantially cuboidal light-emitting element 11 of which the surface to be mounted on the substrate is substantially rectangular, mounted on the light-emitting device shown in Figs. 3 and 4, usually the electrodes in a pair are provided in the vicinity of the center of the short side of a rectangular on the side opposite from the mounting surface 21 of the light-emitting element 11. When such light-emitting elements 11 are used, they are preferably mounted so that the long side of the surface to be mounted of each light-emitting element 11 in parallel with the short side of the mounting surface 21, so that when the electrodes 12 of the light-emitting elements 11 and the wiring conductors 3 are connected as shown in Fig. 3, the bonding wires 13 will not cross. Further, disposing the light-emitting elements 11 in such a direction is preferred also in view of the light-extraction efficiency.

Disposition of the light-emitting elements 11 on the light-emitting device 10 in the present invention is not limited to the disposition shown in Figs. 3 and 4, so long as the bonding wires 13 will not cross at least when the electrodes 12 of the light-emitting elements 11 and the wiring conductors 3 are connected in one-to-one. It may suitably be adjusted considering the number or the shape of the light-emitting elements 11 to be used, the positions of the electrodes 12, the degree of the light-extraction efficiency by the disposition, the positions of the wiring conductors 3, etc.

In the light-emitting device 10, as mentioned above, a Zener diode 15 is mounted on a wiring conductor 3 formed to have a larger area than the others. This Zener diode 15 is electrically connected to another wiring conductor 3 by a bonding wire 13 so as to be electrically connected in parallel to a circuit to which the above two light-emitting elements 11 are connected in parallel. Further, a mold material 14 is provided so as to cover the light-emitting elements 11, the Zener diode 15 and the bonding wires 13 to constitute the light-emitting device 10.

According to the light-emitting device 10 of the present invention, the substrate 1 for mounting light-emitting elements to be used has a constitution such that the wiring conductors 3 are not arranged at a portion between the light-emitting elements 11 with a relatively high light emission intensity, and the reflection film 7 is formed in this portion. Further, since there is no gap between the wiring conductor 3 and the reflection film 7 at a portion between the light-emitting elements 11, the reflection efficiency of light emitted from a plurality of the light-emitting elements 11 will be improved, and entrance of light into the substrate main body 2 can be suppressed, and accordingly such a light-emitting device can emit light with high brightness with a high light-extraction efficiency. Such a light-emitting device 10 can suitably be used, for example, as backlight of cellular phones, large-sized liquid crystal displays, etc., illumination for automobiles or for decoration, or other light sources.

With respect to the substrate 1 for mounting light-emitting elements of the present invention having the above constitutional characteristics, materials and a production process usually employed for a LTCC substrate for mounting light-emitting elements can be applicable without any particular restriction. Further, the light-emitting device 10 of the present invention can also be produced by a conventional method using conventional members except that the substrate 1 for mounting light-emitting elements of the present invention is used.

Now, one example of a process for producing one embodiment of the substrate for mounting light-emitting elements of the present invention, having a substantially rectangular mounting surface, on which two double wire type light-emitting elements are to be mounted so as to be electrically connected in parallel as shown in Figs. 1 and 2, will be described.

### <A case where LTCC substrate is used as substrate main body>

The substrate for mounting light-emitting elements according to one embodiment of the present invention is produced, for example, by a production process comprising the following steps (A) to (E). More specifically, the substrate for mounting light-emitting elements according to the present invention is preferably produced by the following steps (A) to (E) in this order. In the following description, members to be used for its production, layers to be formed, etc. will be described with reference to the same symbols as those of members of a complete product.
(A) A step of preparing a green sheet for main body having a substantially rectangular mounting surface 21 to be partially mounting portions 22 on which light-emitting elements 11 are to be mounted, constituting the substrate main body 2 of the substrate 1 for mounting light-emitting elements, by using a glass ceramic composition containing a glass powder and a ceramic filler (hereinafter referred to as "a step for preparing green sheet for main body").
(B) A step of forming a wiring conductor paste layer at four corners of the substantially rectangular mounting surface 21 of the substrate main body 2, a paste layer for through hole conductor to electrically connect the wiring conductor paste layer to the following conductor paste layer for external electrode terminal formed on the non-mounting surface 23, and a conductor paste layer for external electrode terminal to electrically connect the light-emitting elements 11 in parallel by means of the wiring conductor paste layer and the paste layer for through hole conductor, on the non-mounting surface 23 (hereinafter referred to as "a conductor paste layer forming step").
(C) A step of forming a paste layer for reflection film by screen printing on the mounting surface 21 excluding the wiring conductor paste layer and a periphery thereof (hereinafter referred to as "a step of forming paste layer for reflection film").
(D) A step of forming an overcoat glass paste layer on the mounting surface 21 so as to cover the entire paste layer for reflection film including its edge and so as to exclude the wiring conductor paste layer and a periphery thereof, to obtain a non-sintered substrate for mounting light-emitting elements (hereinafter referred to as "an overcoat glass plate layer forming step").
(E) A step of firing the non-sintered substrate for mounting light-emitting elements at from 800 to 930°C (hereinafter referred to as a firing step).

Now, the respective steps (A) to (F) will be described in detail.

### (A) Step for preparing green sheet for main body

The green sheet 2 for main body is produced by adding a binder and as the case requires, a plasticizer, a dispersing agent, a solvent, etc. to a glass ceramic composition containing a glass powder (a glass powder for substrate main body) and a ceramic filler to prepare a slurry, and forming the slurry into a sheet-form e.g. by a doctor blade method, followed by drying. The green sheet 2 for main body is obtained e.g. by a method of laminating a plurality of green sheets as the case requires, so that as shown in Fig. 2, the substrate main body 2 finally has a cavity on its upper surface, and the bottom of the cavity forms a substantially rectangular mounting surface 21.

The glass powder for substrate main body is not particularly limited, but is preferably one having a glass transition point (Tg) of at least 550°C and at most 700°C. If the glass transition point (Tg) is less than 550°C, binder burn out may be difficult, and if it exceeds 700°C, the shrinkage starting temperature tends to be high, whereby the dimensional accuracy may be decreased.

Further, preferred is one such that when fired at a temperature of at least 800°C and at most 930°C, crystals are deposited. In the case of one such that crystals are not deposited, no sufficient mechanical strength may be obtained. Further, preferred is one having a crystallization peak temperature (Tc) of at most 880°C as measured by DTA (differential thermal analysis). If the crystallization peak temperature (Tc) exceeds 880°C, the dimensional accuracy may be decreased.

Such a glass powder for substrate main body preferably has a glass composition comprising, as represented by mol% as calculated as the following oxides, for example, at least 57 mol% and at most 65 mol% of SiO₂, at least 13 mol% and at most 18 mol% of B₂O₃, at least 9 mol% and at most 23 mol% of CaO and at least 3 mol% and at most 8 mol% of Al₂O₃, containing at least one selected from K₂O and Na₂O, and comprising at least 0.5 mol% and at most 6 mol% of K₂O, Na₂O, or K₂O and Na₂O. By using such a glass powder, flatness of the surface of the substrate main body can easily be improved.

Here, SiO₂ is a component to be a glass network former. If the SiO₂ content is less than 57 mol%, stable glass will hardly be obtained, and chemical durability may also be decreased. On the other hand, if the SiO₂ content exceeds 65 mol%, the glass melting temperature or the glass transition point (Tg) may excessively be high. The SiO₂ content is preferably at least 58 mol%, more preferably at least 59 mol%, particularly preferably at least 60 mol%. Further, the SiO₂ content is preferably at most 64 mol%, more preferably at most 63 mol%.

B₂O₃ is a component to be a glass network former. If the B₂O₃ content is less than 13 mol%, the glass melting temperature or the glass transition point (Tg) may excessively be high. On the other hand, if the B₂O₃ content exceeds 18 mol%, stable glass will hardly be obtained, and the chemical durability may also be decreased. The B₂O₃ content is preferably at least 14 mol%, more preferably at least 15 mol%. Further, the B₂O₃ content is preferably at most 17 mol%, more preferably at most 16 mol%.

Al₂O₃ is added to increase the stability, the chemical durability and the strength of glass. If the Al₂O₃ content is less than 3 mol%, glass may be unstable. On the other hand, if the Al₂O₃ content exceeds 8 mol%, the glass melting temperature or the glass transition point (Tg) may excessively be high. The Al₂O₃ content is preferably at least 4 mol%, more preferably at least 5 mol%. Further, the Al₂O₃ content is preferably at most 7 mol%, more preferably at most 6 mol%.

CaO is added to increase the stability of glass and the precipitation property of crystals and to lower the glass melting temperature or the glass transition point (Tg). If the CaO content is less than 9 mol%, the glass melting temperature may excessively be high. On the other hand, if the CaO content exceeds 23 mol%, glass may be unstable. The CaO content is preferably at least 12 mol%, more preferably at least 13 mol%, particularly preferably at least 14 mol%. Further, the CaO content is preferably at most 22 mol%, more preferably at most 21 mol%, particularly preferably at most 20 mol%.

K₂O or Na₂O is added to lower the glass transition point (Tg). If the total content of K₂O and Na₂O is less than 0.5 mol%, the glass melting temperature or the glass transition point (Tg) may excessively be high. On the other hand, if the total content of K₂O and Na₂O exceeds 6 mol%, the chemical durability, particularly the acid resistance, may be deteriorated, and the electrical insulation property may also be deteriorated. The total content of K₂O and Na₂O is preferably at least 0.8 mol% and at most 5 mol%.

The glass powder for substrate main body is not necessarily limited to one comprising only the above-described components and may contain other components within a range to satisfy various properties such as the glass transition point (Tg). When it contains such other components, their total content is preferably at most 10 mol%.

The glass powder for substrate main body is obtained by producing glass having the above glass composition by a melting method from the glass materials and grinding the obtained glass by a dry grinding method or a wet grinding method. In the case of a wet grinding method, it is preferred to employ water as a solvent. The grinding can be carried out by using a grinding machine such as a roll mill, a ball mill or a jet mill.

The 50% particle size (D₅₀) of the glass powder for substrate main body is preferably at least 0.5 µm and at most 2 µm. If the 50% particle size of the glass powder for substrate main body is less than 0.5 µm, the glass powder is likely to cohere, whereby the handling tends to be difficult, and it tends to be difficult to uniformly disperse it. On the other hand, if the 50% particle size of the glass powder for substrate main body exceeds 2 µm, the glass softening temperature is likely to rise, or the sintering is likely to be inadequate. The particle size can be adjusted, for example, by classification after the grinding as the case requires. In this specification, the particle size is a value measured by a particle size analyzer of a laser diffraction scattering method.

On the other hand, as the ceramic filler, one used for the production of a LTCC substrate heretofore may be used without any particular restriction, and for example, an alumina powder, a zirconia powder or a mixture of an alumina powder and a zirconia powder is preferably employed. The 50% particle size (D₅₀) of the ceramic filler is preferably, for example, at least 0.5 µm and at most 4 µm. In addition to the above, there is a white ceramic filler, but its use is preferably avoided since it may cause drawbacks on the substrate for mounting light-emitting elements. Such drawbacks may, for example, be a decrease in the light reflectance, a decrease in the strength, a decrease in the sintering property, and an increase in the difference in the thermal expansion coefficient with a mounting substrate (for example, a glass epoxy substrate) due to a decrease in the thermal expansion coefficient.

The above glass powder for substrate main body and the ceramic filler are blended and mixed, for example, so that the amount of the glass powder for substrate main body is at least 30 mass% and at most 50 mass%, and the amount of the ceramic filler is at least 50 mass% and at most 70 mass%, to obtain a glass ceramic composition. To this glass ceramic composition, a binder and as the case requires, a plasticizer, a dispersing agent, a solvent, etc. are added to obtain a slurry.

As the binder, for example, polyvinyl butyral or an acrylic resin may be suitably used. As the plasticizer, for example, dibutyl phthalate, dioctyl phthalate or butyl benzyl phthalate may be employed. Further, as the solvent, an organic solvent such as toluene, xylene, 2-propanol or 2-butanol may suitably be employed.

The slurry thus obtained is formed into a sheet-form by e.g. a doctor blade method, followed by drying, and a plurality of such green sheets are laminated as the case requires, to obtain a green sheet 2 for main body which has a cavity on its upper surface, the bottom of the cavity being substantially rectangular as the mounting surface 21.

### (B) Formation of conductor paste layer

Then, a wiring conductor paste layer 3 is formed at four corners on the substantially rectangular mounting surface 21 of the green sheet 2 for main body thus obtained, a paste layer 6 for through hole conductor to electrically connect the wiring conductor paste layer 3 at four portions to the following conductor paste layer 4 for external electrode terminal formed on the non-mounting surface 23 is formed, and a conductor paste layer 4 for external electrode terminal to electrically connect two light-emitting elements to be mounted on the mounting portion 22 in parallel by means of the wiring conductor paste layer 3 and the paste layer 6 for through hole conductor, is formed on the non-mounting surface 23, each in a predetermined size and shape. Hereinafter, the green sheet for main body having various conductor paste layers formed thereon will be referred to as a green sheet 2 for main body provided with conductor paste layers.

As a method for forming the wiring conductor paste layer 3, the conductor paste layer 4 for external electrode terminal and the paste layer 6 for through hole conductor, a method of applying and filling a conductor paste by a screen printing method may be mentioned. The thickness of the wiring conductor paste layer 3 and the paste layer 4 for external electrode terminal to be formed is adjusted so that the wiring conductor, the external electrode terminal and the like to be finally obtained have predetermined thicknesses.

As the conductor paste, it is possible to use one having a vehicle such as ethyl cellulose, and as the case requires, a solvent etc. added to a metal powder comprising e.g. copper, silver or gold as the main component to form a paste. Further, as the above metal powder, a metal powder comprising silver, a metal powder comprising silver and platinum or a metal powder comprising silver and palladium may preferably be employed.

### (C) Step of forming paste layer for reflection film

In (C) the step of forming paste layer for reflection film, a paste layer 7 for reflection film containing a material having reflection properties to be a reflection film 7 is formed by screen printing so as to exclude the regions on which the wiring conductor paste layer 3 is formed and a periphery thereof on the substantially rectangular mounting surface 21 of the green sheet 2 for main body provided with conductor paste layers obtained in the above step (B). (C) The step of forming paste layer for reflection film may be carried out simultaneously with formation of the wiring conductor paste layer 3 in the above step (B), for example, in a case where the wiring conductor paste and the paste for reflection film are made of the same paste material.

The paste for reflection film to be used for screen printing is a paste containing a material having reflection properties constituting the reflection film 7. Such a material may, for example, be silver, a mixture of silver with palladium, a silver/palladium alloy, a mixture of silver with platinum, or a silver/platinum alloy, as mentioned above, and a silver paste containing at least 95% of silver is preferably used, which has a high reflectance. The paste may contain at most 5% of glass frit to improve the adhesion strength. As the paste for reflection film, one having a vehicle such as ethyl cellulose and as the case requires, a solvent, etc. added to a metal powder containing such a material as the main component, to form a paste, may be used. The thickness of the paste layer 7 for reflection film to be formed is adjusted so that the thickness of the reflection film 7 to be finally obtained is the above desired thickness.

### (D) Overcoat glass paste layer forming step

In (D) the overcoat glass paste layer forming step, on the mounting surface 21, an overcoat glass paste layer 8 is formed by screen printing so as to cover the entire paste layer 7 for reflection film formed in the above step (C) including its edge and so as to exclude the wiring conductor paste layer 3 formed in the above step (B) and a periphery thereof, whereby a non-sintered substrate 1 for mounting light-emitting elements is obtained.

As the overcoat glass paste, it is possible to use one having a vehicle such as ethyl cellulose and as the case requires, a solvent etc. added to a glass powder (glass powder for glass film) to form a paste. The thickness of the overcoat glass paste layer 8 to be formed is adjusted so that the thickness of the overcoat glass film 8 to be finally obtained is the above desired thickness.

The glass powder for glass film may be one whereby film-form glass is obtainable by firing in the step (E) carried out after the step (D), and its 50% particle size (D₅₀) is preferably at least 0.5 µm and at most 2 µm. Further, the surface roughness Ra of the overcoat glass film 8 may be adjusted, for example, by suitably selecting the particle size of the glass powder for glass film and blending such glass. That is, by using, as the glass powder for glass film, one which can be sufficiently melted during firing and is excellent in fluidity, it is possible to reduce the surface roughness Ra.

### (E) Firing step

After the above step (D), with respect to the obtained non-sintered substrate 1 for mounting light-emitting elements, binder burn out to remove the binder, etc., is carried out as the case requires and then, firing is carried out to sinter the glass ceramic composition, etc. to obtain a substrate 1 for mounting light-emitting elements.

The binder burn out is carried out by holding the substrate, for example, at a temperature of at least 500°C and at most 600°C for at least one hour and at most 10 hours. If the binder burn out temperature is lower than 500°C or the binder burn out time is less than one hour, the binder, etc. may not sufficiently be removed. When the binder burn out temperature is about 600°C and the binder burn out time is about 10 hours, the binder, etc. can sufficiently be removed, and if the binder burn out temperature or time exceeds the above range, the productivity, etc. may rather be deteriorated.

Further, the firing is carried out by suitably adjusting the time within a temperature range of from 800°C to 930°C in consideration of the productivity of the substrate main body and securing a dense structure of the substrate main body. Specifically, it is preferred to hold the substrate at a temperature of at least 850°C and at most 900°C for at least 20 minutes and at most 60 minutes, particularly preferably at a temperature of at least 860°C and at most 880°C. If the firing temperature is lower than 800°C, the substrate main body may not have a dense structure. On the other hand, if the firing temperature exceeds 930°C, the productivity etc. may deteriorate, for such a reason that the substrate main body undergoes deformation. Further, in a case where a metal paste containing a metal powder containing silver as the main component is used as the above conductor paste or paste for reflection film, if the firing temperature exceeds 880°C, softening proceeds excessively, and a prescribed shape may not be maintained.

In such a manner, the non-sintered substrate 1 for mounting light-emitting elements is fired and a substrate 1 for mounting light-emitting elements is obtained, and after firing, as the case requires, it is possible to provide an electrically conductive protective film which is usually employed to protect the conductors for the substrate for mounting light-emitting elements, such as gold plating, so as to cover the entire wiring conductors 3.

The process for producing a substrate 1 for mounting light-emitting elements using a glass ceramic composition containing a glass powder and a ceramic filler is described above, however, the green sheet 2 for main body may not necessarily be a single green sheet and may be a laminate of a plurality of green sheets. Further, the order of forming the respective members, etc. may suitably be changed so long as the substrate 1 for mounting light-emitting elements can be produced.

### <A case where alumina substrate is used as substrate main body>

The substrate for mounting light-emitting elements according to another embodiment of the present invention is produced, for example, by a production process comprising the following steps (a) to (f). More specifically, the substrate for mounting light-emitting elements according to the present invention is preferably produced by the following steps (a) to (f) in this order. In the following description, members to be used for its production, layers to be formed, etc. will be described with reference to the same symbols as those of members of a complete product.
(a) A step of preparing a green sheet for main body having a substantially rectangular mounting surface 21 to be partially mounting portions 22 on which light-emitting elements 11 are to be mounted, constituting the substrate main body 2 of the substrate 1 for mounting light-emitting elements, by using an alumina ceramic composition containing an alumina powder and a sintering aid (step of preparing green sheet for main body).
(b) A step of firing the green sheet for main body at from 1,400 to 1,600°C (first firing step).
(c) A step of forming a paste layer for through hole conductor to electrically connect the wiring conductor paste layer at four corners on the substantially rectangular mounting surface 21 of the substrate main body 2 after firing, and a conductor paste for external electrode terminal to electrically connect the light-emitting elements 11 in parallel by means of the wiring conductor paste layer and the paste layer for though hole conductor, on the non-mounting surface 23 (conductor paste layer forming step).
(d) A step of forming a paste layer for reflection film by screen printing on the mounting surface 21 excluding the wiring conductor paste layer and a periphery thereof (step of forming paste layer for reflection film).
(e) A step of forming an overcoat glass paste layer on the mounting surface 21 so as to cover the entire paste layer for reflection film including its edge and so as to exclude the wiring conductor paste layer and a periphery thereof, to obtain a substrate precursor for mounting light-emitting elements (overcoat glass paste layer forming step).
(f) A step of firing the substrate precursor for mounting light-emitting elements at from 850 to 900°C (second firing step).

Now, the above respective steps (a) to (f) will be described in further detail below.

### (a) Step of preparing green sheet for main body

The green sheet 2 for main body is produced by adding a binder and as the case requires, a plasticizer, a solvent, etc. to an alumina ceramic composition containing an alumina powder and a sintering aid to prepare a slurry, and forming the slurry into a sheet-form e.g. by a doctor blade method, followed by drying.

The 50% particle size (D₅₀) of the alumina powder is preferably at least 0.5 µm and at most 2 µm. If D₅₀ of the alumina powder is less than 0.5 µm, the alumina powder is likely to cohere, whereby the handling tends to be difficult, and it tends to be difficult to uniformly disperse it. On the other hand, if D₅₀ exceeds 2 µm, the sintering is likely to be inadequate.

As the sintering aid, those which have been used for production of a ceramic substrate may be used. For example, a mixture of SiO₂ and an alkaline earth metal oxide may suitably be used. D₅₀ of the sintering aid is preferably at least 0.5 µm and at most 4 µm.

Such an alumina powder and a sintering aid are blended and mixed, for example, so that the amount of the alumina powder is at least 80 mass% and at most 99 mass%, and the amount of the sintering aid is at least 1 mass% and at most 20 mass%, to obtain an alumina ceramic composition. To the alumina ceramic composition, a binder and as the case requires, a plasticizer, a solvent, etc. are added to prepare a slurry.

As the binder, for example, polyvinyl butyral or an acrylic resin may be suitably used. As the plasticizer, for example, dibutyl phthalate, dioctyl phthalate or butyl benzyl phthalate may be employed. Further, as the solvent, an aromatic or alcohol organic solvent such as toluene, xylene or butanol may be employed. Further, a dispersing agent or a leveling agent may be used in combination.

The slurry thus obtained is formed into a sheet form e.g. by a doctor blade method, followed by drying, the sheet is cut into a square having predetermined dimensions by using a cutting die or a punching machine, and at the same time, via holes for interlayer connection are formed by punching at predetermined positions to produce the green sheet 2 for main body.

### (b) First firing step

The non-fired green sheet 2 for main body is heated at a temperature of at least 500°C and at most 600°C, to carry out binder burn out to decompose and remove the binder such as a resin contained in the green sheet. In a case where a plurality of non-fired green sheets 2 for main body are laminated, a plurality of the green sheets are overlaid with positioning, heated and pressurized so that they are bonded, and then the above binder burn out is carried out. Then, the green sheet is further heated at a temperature at a level of from 1,400 to 1,600°C, to fire the alumina ceramic composition constituting the green sheet for main body, thereby to obtain an alumina substrate 2 as the substrate main body.

### (c) Conductor paste layer forming step

Then, a wiring conductor paste layer 3 is formed at four corners on the substantially rectangular mounting surface 21 of the alumina substrate 2 thus obtained, a paste layer 6 for through hole conductor to electrically connect the wiring conductor paste layer 3 at four portions to the following conductor paste layer 4 for external electrode terminal formed on the non-mounting surface 23 is formed, and a conductor paste layer 4 for external electrode terminal to electrically connect two light-emitting elements to be mounted on the mounting portion 22 in parallel by means of the wiring conductor paste layer 3 and the paste layer 6 for through hole conductor, is formed on the non-mounting surface 23, each in a predetermined size and shape. Hereinafter, the alumina substrate 2 having various conductor paste layers formed thereon will be referred to as an alumina substrate 2 provided with conductor paste layers.

As a method for forming the wiring conductor paste layer 3, the conductor paste layer 4 for external electrode terminal and the paste layer 6 for through hole conductor, a method of applying and filling a conductor paste by a screen printing method may be mentioned. The thickness of the wiring conductor paste layer 3 and the paste layer 4 for external electrode terminal to be formed is adjusted so that the wiring conductor, the external electrode terminal and the like to be finally obtained have predetermined thicknesses.

As the conductor paste, it is possible to use one having a vehicle such as ethyl cellulose, and as the case requires, a solvent etc. added to a metal powder comprising e.g. copper, silver or gold as the main component to form a paste. Further, as the above metal powder, a metal powder comprising silver, a metal powder comprising silver and platinum or a metal powder comprising silver and palladium may preferably be employed. Further, in order to sufficiently secure the adhesive force between the metal powder and the alumina substrate, a conductor paste having a small amount of glass frit blended may be used.

### (d) Step of forming paste layer for reflection film

In (d) the step of forming paste layer for reflection film, a paste layer 7 for reflection film containing a material having reflection properties to be a reflection film 7 is formed by screen printing so as to exclude the regions on which the wiring conductor paste layer 3 is formed and a periphery thereof on the substantially rectangular mounting surface 21 of the alumina substrate 2 provided with conductor paste layers obtained in the above step (c). (d) The step of forming paste layer for reflection film may be carried out simultaneously with formation of the wiring conductor paste layer 3 in the above step (c), for example, in a case where the wiring conductor paste and the paste for reflection film are made of the same paste material.

The paste for reflection film to be used for screen printing is a paste containing a material having reflection properties constituting the reflection film 7. Such a material may, for example, be silver, a mixture of silver with palladium, a silver/palladium alloy, a mixture of silver with platinum, or a silver/platinum alloy, as mentioned above, and a silver paste containing at least 95% of silver is preferably used, which has a high reflectance. The paste may contain at most 5% of glass frit to improve the adhesion strength. As the paste for reflection film, one having a vehicle such as ethyl cellulose and as the case requires, a solvent, etc. added to a metal powder containing such a material as the main component, to form a paste, may be used. The thickness of the paste layer 7 for reflection film to be formed is adjusted so that the thickness of the reflection film 7 to be finally obtained is the above desired thickness.

### (e) Overcoat glass paste layer forming step

In (e) the overcoat glass paste layer forming step, on the mounting surface 21, an overcoat glass paste layer 8 is formed by screen printing so as to cover the entire paste layer 7 for reflection film formed in the above step (d) including its edge and so as to exclude the wiring conductor paste layer 3 formed in the above step (c) and a periphery thereof, whereby a substrate precursor 1 for mounting light-emitting elements is obtained.

As the overcoat glass paste, it is possible to use one having a vehicle such as ethyl cellulose and as the case requires, a solvent etc. added to a glass powder (glass powder for glass film) to form a paste. The thickness of the overcoat glass paste layer 8 to be formed is adjusted so that the thickness of the overcoat glass film 8 to be finally obtained is the above desired thickness.

The glass powder for glass film may be one whereby film-form glass is obtainable by firing in the step (f) carried out after the step (e), and its 50% particle size (D₅₀) is preferably at least 0.5 µm and at most 2 µm. Further, the surface roughness Ra of the overcoat glass film 8 may be adjusted, for example, by suitably selecting the particle size of the glass powder for glass film and blending such glass. That is, by using, as the glass powder for glass film, one which can be sufficiently melted during firing and is excellent in fluidity, it is possible to reduce the surface roughness Ra.

### (f) Second firing step

With respect to the substrate precursor 1 for mounting light-emitting elements obtained in the above step (e), binder burn out to remove the binder, etc., is carried out as the case requires, and then firing is carried out to sinter the paste layers formed in the interior (via holes) and on the front and rear surfaces of the alumina substrate, to obtain a substrate 1 for mounting light-emitting elements having wiring conductors 3, a reflection film 7 and an overcoat glass film 8 formed thereon.

The binder burn out is carried out by holding the substrate, for example, at a temperature of at least 500°C and at most 600°C for at least one hour and at most 10 hours. If the binder burn out temperature is lower than 500°C or the binder burn out time is less than one hour, the binder, etc. may not sufficiently be removed. When the binder burn out temperature is about 600°C and the binder burn out time is about 10 hours, the binder, etc. can sufficiently be removed, and if the binder burn out temperature or time exceeds the above range, the productivity, etc. may rather be deteriorated.

Further, the firing is carried out by suitably adjusting the time within a temperature range of from 850°C to 900°C in consideration of the degree of sintering and the flatness of the wiring conductors 3, the reflection film 7, the overcoat glass film, etc. It is particularly preferably carried out at a temperature of at least 860°C and at most 880°C. If the firing temperature is lower than 850°C, sintering of the conductor paste or the paste 7 for reflection film tends to be poor, and no dense structure may be obtained. Further, with respect to the overcoat glass paste 8, the flatness of the surface may not be sufficient due to insufficient fluidity. On the other hand, if the firing temperature exceeds 900°C, the productivity etc. may deteriorate, for such a reason that the conductor paste or the paste for reflection film undergoes deformation. Particularly, in a case where a metal paste containing a metal powder containing silver as the main component is used as the above conductor paste or paste for reflection film, if the firing temperature exceeds 880°C, softening proceeds excessively, and a prescribed shape may not be maintained.

In such a manner, the substrate 1 for mounting light-emitting elements is obtained, and after firing, as the case requires, it is possible to provide an electrically conductive protective film which is usually employed to protect the conductors for the substrate for mounting light-emitting elements, such as gold plating, so as to cover the entire wiring conductors 3.

### EXAMPLES

Now, the present invention will be described in detail with reference to Examples. However, it should be understood that the present invention is by no means restricted thereto.

### [Example 1]

By the following method, a test substrate for mounting light-emitting elements having the same constitution of the substrate for mounting light-emitting elements as shown in Figs. 3 and 4, and a test light-emitting device using the substrate were prepared. Further, in the following description in Examples, regarding members to be used for production, layers to be formed, etc., symbols for the members, the layers, etc. are the same between before and after firing.

First, a green sheet 2 for main body to prepare a main body substrate 2 of the substrate 1 for mounting light-emitting elements was prepared. As a glass powder to produce the green sheet 2 for main body, glass materials were blended and mixed to achieve a glass composition comprising, as represented by mol% as calculated as the following oxides, 60.4 mol% of SiO₂, 15.6 mol% of B₂O₃, 6 mol% of Al₂O₃, 15 mol% of CaO, 1 mol% of K₂O and 2 mol% of Na₂O, the material mixture was put in a platinum crucible and melted at 1,600°C for 60 minutes, and glass in a molten state was cast and cooled. The obtained glass was ground by an alumina ball mill for 40 hours to produce a glass powder for substrate main body. As a solvent at the time of grinding, ethyl alcohol was used.

40 mass% of the glass powder for substrate main body and 60 mass% of an alumina filler (manufactured by Showa Denko K.K., tradename: AL-45H) were blended and mixed to produce a glass ceramic composition. With 50 g of this glass ceramic composition, 15 g of an organic solvent (a mixture of toluene, xylene, 2-propanol and 2-butanol with a mass ratio of 4:2:2:1), 2.5 g of a plasticizer (di-2-ethylhexyl phthalate), 5 g of polyvinyl butyral (manufactured by Denki Kagaku Kogyo Kabushiki Kaisha, tradename: PVK#3000K) as a binder and 0.5 g of a dispersing agent (manufactured by BYK Japan KK, tradename: BYK180) were blended and mixed to prepare a slurry.

This slurry was applied on a PET film by a doctor blade method and dried, and a plurality of such green sheets thus obtained were laminated to produce a green sheet for main body, which was in a substantially plate form, and which has a cavity constituting a mounting surface of which the bottom was substantially rectangular, on the upper surface, and the thickness at the bottom of the cavity after firing being 0.15 mm.

Further, an electrically conductive powder (silver powder, manufactured by DAIKEN CHEMICAL CO., LTD., tradename: S550) and ethyl cellulose as a vehicle were blended in a mass ratio of 85:15, and dispersed in α-terpineol as a solvent so that the solid content became 85 mass%, and the dispersion was kneaded in a porcelain mortar for one hour and further dispersed three times by a triple roll to prepare a metal paste.

Through holes having a diameter of 0.3 mm were formed at portions corresponding to the non-fired through hole conductors 6 of the green sheet 2 for main body by a punching machine, and filled with a metal paste by a screen printing method to form a non-fired through hole conductor paste layer 6 and in addition, a non-fired external electrode terminal conductor paste layer 4 was formed on the non-mounting surface 23 and a wiring conductor paste layer 3 was formed at four corners on the mounting surface 21 of the green sheet 2 for main body so that the wiring conductor paste layer 3 has a larger area at one portion than the other three portions, to obtain a green sheet 2 for main body provided with conductor paste layers. These conductor paste layers were formed so that when two double wire type light-emitting diode elements are mounted on a substrate for mounting light-emitting elements obtainable by firing and they are electrically connected by wire bonding, they are electrically connected in parallel.

A paste layer 7 for silver reflection film was formed by a screen printing method on the mounting surface 21 of the green sheet 2 for main body provided with conductor paste layers excluding the wiring conductor paste layer 3 and a periphery thereof. On the paste layer 7, an overcoat glass paste layer 8 was formed by a screen printing method so as to cover the entire paste layer 7 for silver reflection film including its edge and so as to exclude the wiring conductor paste layer 3 and a periphery thereof, to obtain a non-fired substrate 1 for mounting light-emitting elements.

The above obtained non-fired substrate 1 for mounting light-emitting elements was held at 550°C for 5 hours to carry out binder burn out and further held at 870°C for 30 minutes to carry out firing thereby to produce a test substrate 1 for mounting light-emitting elements.

The above paste for silver reflection film was prepared in such a manner that a silver powder (manufactured by DAIKEN CHEMICAL CO., LTD., tradename: S400-2) and ethyl cellulose as a vehicle were blended in a mass ratio of 90:10 and dispersed in α-terpineol as a solvent so that the solid content became 87 mass%, and the dispersion was kneaded in a porcelain mortar for one hour and further dispersed three times by a triple roll. Further, the glass powder for glass film used for preparation of the overcoat glass paste was produced as follows. First, glass materials were blended and mixed to achieve a glass composition comprising, as represented by mol% as calculated as the following oxides, 81.6 mol% of SiO₂, 16.6 mol% of B₂O₃ and 1.8 mol% of K₂O, this material mixture was put in a platinum crucible and melted at 1,600°C for 60 minutes, and glass in a molten state was cast and cooled. The obtained glass was ground by an alumina ball mill for from 8 to 60 hours to obtain a glass powder for glass film.

60 mass% of the glass powder for overcoat glass film and 40 mass% of a resin component (one containing ethyl cellulose and α-terpineol in a mass ratio of 85:15) were blended and kneaded in a porcelain mortar for one hour, and further dispersed three times by a triple roll to prepare an overcoat glass paste.

On the test substrate 1 for mounting light-emitting elements thus prepared, two double wire type light-emitting diode elements were mounted on the mounting portions 22 so that the long side of the surface to be mounted on the substrate of each light-emitting diode element was in parallel with the short side of the mounting surface of the substrate and that they were positioned at substantially center portions of regions formed by equally dividing the portion on which the silver reflection film and the overcoat glass film were provided on the substrate mounting surface by a line in parallel with the short side of the mounting surface, as shown in Fig. 1, to prepare a light-emitting element 10. Specifically, to the two mounting portions 22, light-emitting diode elements 11 (manufactured by Showa Denko K.K., tradename: GQ2CR460Z) were respectively fixed by a die bonding material (manufactured by Shin-Etsu Chemical Co., Ltd., tradename: KER-3000-M2), and electrodes 12 in a pair of the light-emitting diode elements 11 were electrically connected to the wiring conductors 3 by bonding wires 13. Further, a Zener diode 15 was mounted on the wiring conductor 3 formed to have a larger area than the other wiring conductors 3, and connected to another wiring conductor 3 by a bonding wire 13 so that the two light-emitting diode elements were connected in parallel to a circuit electrically connected in parallel.

Further, sealing was conducted to constitute the mold material 14 as shown in Fig. 4 by using a sealing agent (manufactured by Shin-Etsu Chemical Co., Ltd., tradename: SCR-1016A). As the sealing agent, one containing 20 mass% of a phosphor (manufactured by Kasei Optonix, Ltd., tradename: P46-Y3) based on the sealing agent, was used.

### [Example 2]

Using the same glass powder as in Example 1, 38 mass% of the glass powder, 38 mass% of an alumina filler (manufactured by Showa Denko K.K., tradename: AL-45H) and 24 mass% of a zirconia filler (manufactured by DAIICHI KIGENSO KAGAKU KOGYO CO., LTD., tradename: HSY-3F-J) were blended and mixed to produce a glass ceramic composition. Substantially in the same manner as in Example 1 except for the above, a substrate for mounting light-emitting elements was prepared, light-emitting diode elements were connected, and sealing was conducted by using a sealing agent.

In the obtained light-emitting device 10, two light-emitting diode elements were electrically connected in parallel, and the Zener diode 15 was electrically connected in parallel to the circuit. The total flux with respect to the light-emitting device 10 prepared in Example 1 and the total flux with respect to the following light-emitting device corresponding to a conventional light-emitting device were measured and compared by the following method, whereupon the light-emitting device 10 had a flux improved by 10% as compared with the conventional light-emitting device. Further, the light-emitting device in Example 2 had a flux improved by 25% as compared with the conventional light-emitting device.

Measurement of the total flux was carried out by a LED total flux measuring apparatus SOLID LAMBDA CCD LED MONITOR PLUS manufactured by Spectra Coop. The integrating sphere was 6 inch, and as a voltage/current generator, R6243 manufactured by ADVANTEST CORPORATION was used. Further, 35 mA was applied to the LED element for measurement.

### <Conventional light-emitting device>

A test light-emitting device having a conventional constitution using the same substrate for mounting light-emitting elements as in Example 1 except that two wiring conductors 3 were formed at a portion between two light-emitting elements 11 on the substantially rectangular mounting surface, and that one wiring conductor was formed so as to be in contact with one of the two short sides, and two wiring conductors 3 were formed to be in contact with the other short side, as shown in Figs. 5 and 6. The wiring conductors 3 were prepared by using the same material as for the through hole conductor 6 and the external electrode terminal 4. The two double wire type light-emitting diode elements mounted on the light-emitting device were also the same as in Example 1, and they were mounted so that the short side of the surface to be mounted on the substrate of each light-emitting diode element was in parallel with the short side of the mounting surface of the substrate, so that the length of the after-mentioned bonding wire became shortest. In the conventional light-emitting device 10, the electrodes 12 of the light-emitting diode elements and the Zener diode 15 were connected to the wiring conductors 3 by bonding wires 13 so that the two light-emitting diode elements were electrically connected in parallel, and the Zener diode 15 was also electrically connected in parallel to the circuit.

### INDUSTRIAL APPLICABILITY

According to the substrate for mounting light-emitting elements of the present invention, on a LTCC substrate for mounting light-emitting elements on which a plurality of double wire type light-emitting elements are to be mounted so as to be electrically connected in parallel, a reflection film to be formed together with wiring conductors on the substrate is disposed in a large area and effectively, and when such a substrate is used for a light-emitting device, the light-emitting device can emit light with high brightness with a high light-extraction efficiency. The light-emitting device of the present invention using such a substrate for mounting light-emitting elements may suitably be used, for example, as backlights for e.g. cellular phones or large-sized liquid crystal displays, illumination for automobiles or for decoration, or other light sources.

The entire disclosure of Japanese Patent Application No. 2010-039850 filed on February 5, 2010 including specification, claims, drawings and summary is incorporated herein by reference in its entirety.

### REFERENCE SYMBOLS

1: Substrate for mounting light-emitting elements, 2: substrate main body, 3: wiring conductor, 7: reflection film, 8: overcoat glass film, 10: light-emitting device, 11: light-emitting element, 12: electrode of light-emitting element, 13: bonding wire, 21: mounting surface, 22: mounting portion, 23: non-mounting surface, 24: portion between light-emitting elements.

## Claims

1. A substrate for mounting light-emitting elements to mount a plurality of light-emitting elements in such a form that each of electrodes in a pair is connected to the substrate by wire bonding, so as to be electrically connected in parallel, comprising:
a substrate main body made of a sintered product of an inorganic material powder and having a mounting surface to be partially mounting portions on which the light-emitting elements are to be mounted,
at least multiple times the number of the light-emitting elements of wiring conductors provided so as to be connected to the respective electrodes in a pair which the light-emitting elements have, in one-to-one by wire bonding, at a position out of a portion between the light-emitting elements, on the mounting surface of the substrate main body,
a reflection film formed on the mounting surface excluding the wiring conductors and a periphery thereof, and
an overcoat glass film provided on the mounting surface so as to cover the entire reflection film including its edge and so as to exclude the wiring conductors and a periphery thereof.

2. The substrate for mounting light-emitting elements according to Claim 1, wherein the sintered product of the inorganic material powder is a sintered product of a glass ceramic composition containing a glass powder and a ceramic filler.

3. The substrate for mounting light-emitting elements according to Claim 1, wherein the sintered product of the inorganic material powder is a sintered product of an alumina ceramic composition containing an alumina powder and a sintering aid.

4. The substrate for mounting light-emitting elements according to any one of Claims 1 to 3, wherein two light-emitting element are disposed, the mounting surface is substantially rectangular, the mounting portions are at substantially the center portions in regions formed by equally dividing the mounting surface by a line in parallel with its short side, and the wiring conductors are arranged at four corners of the mounting surface.

5. The substrate for mounting light-emitting elements according to any one of Claims 1 to 4, wherein any one of the wiring conductors is formed to have a larger area than the other wiring conductors, for mounting a Zener diode.

6. The substrate for mounting light-emitting elements according to any one of Claims 1 to 5, wherein the reflection film consists essentially of silver.

7. A light-emitting device comprising the substrate for mounting light-emitting elements as defined in any one of Claims 1 to 6, and a plurality of light-emitting elements in such a form that each of electrodes in a pair is connected to the substrate by wire bonding, mounted on the mounting portions of the substrate for mounting light-emitting elements so as to be electrically connected in parallel, wherein the respective electrodes in a pair which the light-emitting elements have, are connected to the wiring conductors in one-to-one by wire bonding.

8. The light-emitting device according to Claim 7, wherein the plurality of light-emitting elements are two substantially cuboidal light-emitting elements of which the surface to be mounted on the substrate is substantially rectangular, the mounting surface of the substrate is substantially rectangular, and the light-emitting elements are mounted on substantially center portions of regions formed by equally dividing the mounting surface of the substrate by a line in parallel with its short side, so that the long side of the surface on which the light-emitting elements are to be mounted is in parallel with the short side of the mounting surface of the substrate.
